Europäisches Patentamt

European Patent Office

Office européen des brevets

(19)

(11) Veröffentlichungsnummer: **0 100 837**
A2

# (12) EUROPÄISCHE PATENTANMELDUNG

(21) Anmeldenummer: **83105789.8**

(51) Int. Cl.³: **H 01 L 23/30**

(22) Anmeldetag: **13.06.83**

(30) Priorität: **18.06.82 DE 3222791**

(43) Veröffentlichungstag der Anmeldung:
**22.02.84 Patentblatt 84/8**

(84) Benannte Vertragsstaaten:
**DE FR GB IT**

(71) Anmelder: **SIEMENS AKTIENGESELLSCHAFT
Berlin und München Wittelsbacherplatz 2
D-8000 München 2(DE)**

(72) Erfinder: **Rücker, Dieter, Dr. Dipl.-Ing.
Forststrasse 42
D-8021 Schäftlarn(DE)**

(54) Verfahren zum Herstellen von umhüllten Halbleiterbauelementen.

(57) Die Erfindung betrifft ein Verfahren zum Herstellen von Halbleiter-Bauelementen, bei dem ein Halbleiter-Chip (1) mit einer dauerelastischen Masse (3) abgedeckt und mit einem mit einem Füllstoff gemischten Kunststoff (4) umhüllt wird und bei dem die dauerelastische Masse (3) mit Hohlräumen (6) versehen wird.

FIG 1

EP 0 100 837 A2

0100837

SIEMENS AKTIENGESELLSCHAFT
Berlin und München

Unser Zeichen
VPA 82 P 1 4 63 E

BEZEICHNUNG GEÄNDERT
siehe Titelseite

Verfahren zum Herstellen von Halbleiter-Bauelementen

Die Erfindung betrifft ein Verfahren zum Herstellen von
Halbleiter-Bauelementen, bei dem ein Halbleiter-Chip
mit einer dauerelastischen Masse abgedeckt und mit einem
mit einem Füllstoff gemischtem Kunststoff umhüllt wird.

Zur Umhüllung von Halbleiteranordnungen, wie z. B. Halbleiter-Chips werden, wie beispielsweise aus der DE-PS
17 89 053, der DE-OS 21 48 690 und der DE-OS 21 64 100
bekannt, Kunststoffe benutzt, die mit einem hohen Anteil
an anorganischen Feststoffen gefüllt sind, um den thermischen Ausdehnungskoeffizienten des Kunststoffes so gut
wie möglich auf den der eingebetteten Metalle, wie z. B.
Halbleiter-Chip und Kontaktierspinne, anzupassen. Als
Kunststoffe werden beispielsweise Epoxide und Silikone
benutzt, während als anorganische Feststoffe beispielsweise Quarzsand oder Quarzmehl verwendet werden. Diese
gefüllten Kunststoffe haben den Nachteil, daß einerseits
die Füllstoffe oft leicht radioaktive Verunreinigungen
enthalten, die sich besonders ungünstig auf Chips für
Halbleiterspeicher auswirken, und daß zum anderen die
gefüllte Kunststoffmasse sehr hart wird, was schon beim
Umspritzen bzw. Umgießen des Halbleiter-Chips zu Beschädigungen der Kontaktierungsanschlüsse führen kann
oder aber nach Aushärten der gefüllten Kunststoffmasse
bei Temperaturwechselbelastung wegen der noch leicht
unterschiedlichen Ausdehnungskoeffizienten der beteiligten Materialien zu einem Abreißen der Anschlüsse führen
kann, und daß außerdem diese gefüllten Kunststoffe eine

Nte 1 Hub / 15.06.1982

für die Halbleiteroberfläche nicht optimale chemische Zusammensetzung haben, die eventuell z. B. zu einer Korrosion der Al-Leiterbahnen führen kann.

Wie z. B. aus Electronics, 11. Sept. 1980, Seiten 41, 42, bekannt, wurde bereits versucht, diese ersten beiden Probleme bei einem Verfahren der eingangs genannten Art dadurch zu vermeiden, daß der kontaktierte Halbleiter-Chip erst durch eine dauerelastische ungefüllte Masse, wie z.B. Silikonkautschuk, abgedeckt wird, ehe er von der gefüllten Masse ummantelt wird.

Dadurch läßt sich zwar eine Abschirmung des Halbleiter-Chips, insbesondere vor schädlichen Alpha-Strahlen und ein gewisser mechanischer Schutz während des Umpressens bzw. Umgießens erreichen, die dauerelastische Masse ist jedoch nach dem Aushärten der Umhüllung in der Regel vollständig von der harten Masse umgeben, so daß sie nicht mehr ausweichen kann und durch Temperaturänderungen verursachte Längenausdehnungen der Ummantelung und der elastischen Masse hart auf den Halbleiter-Chip und seine Kontakte überträgt. Dadurch kommt es erfahrungsgemäß zu wesentlich mehr sogenannten "Thermokontakten" (Unterbrechungen) als bei Weglassen dieser aus einer nicht gefüllten dauerelastischen Masse bestehenden Abdeckung, die einen höheren Ausdehnungskoeffizienten als eine gefüllte Masse hat.

Aufgabe der Erfindung ist es, hier Abhilfe zu schaffen, und ein Verfahren zum Herstellen von Halbleiterbauelementen vorzusehen, mit dem Beschädigungen der Kontaktierungsanschlüsse vermieden werden.

Diese Aufgabe wird bei einem Verfahren der eingangs genannten Art erfindungsgemäß dadurch gelöst, daß die dauerelastische Masse mit Hohlräumen versehen wird. Die Hohlräume sorgen dafür, daß die Elastizität und Nachgiebigkeit der dauerelastischen Masse auch nach dem Ummanteln mit einer harten Masse erhalten bleibt.

Ausgestaltungen des erfindungsgemäßen Verfahrens sind in Unteransprüchen gekennzeichnet.

Die Erfindung wird im folgenden anhand zweier Figuren, die je einen Schnitt durch ein als Ausführungsbeispiel zu wertendes, nach dem erfindungsgemäßen Verfahren hergestelltes Halbleiter-Bauelement zeigen, näher erläutert.

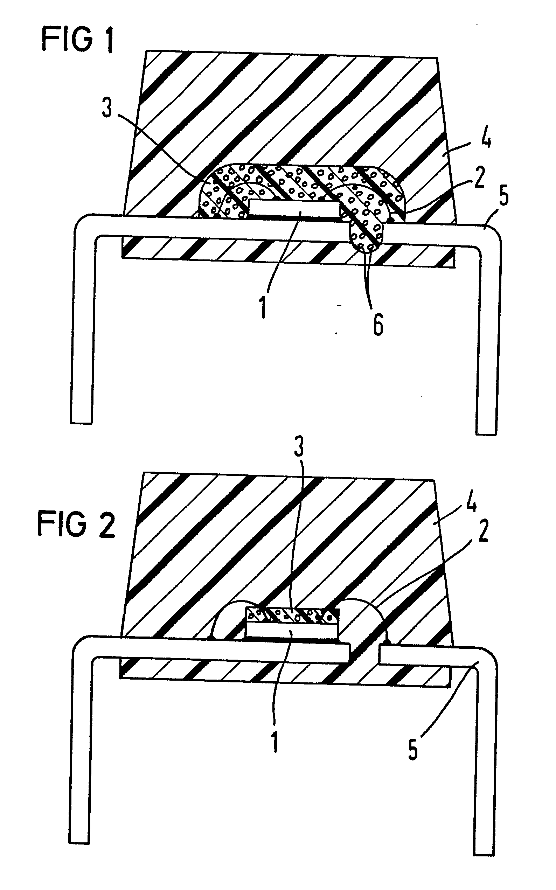

Das in Fig. 1 gezeigte Ausführungsbeispiel zeigt einen Schnitt durch ein, mit einem sogenannten Dual-In-Line-Gehäuse, d. h. ein Gehäuse mit in zwei Reihen angeordneten Anschlüssen, versehenes Halbleiter-Bauelement. Das Bauelement besteht aus einem Halbleiter-Chip 1, dessen Anschlußkontakte in üblicher Weise über Kontaktierungsdrähte 2 mit aus Metallblech bestehenden Leiterbändern 5 verbunden sind. Der bereits kontaktierte ("gebondete") Halbleiter-Chip 1 wird mit einer dauerelastischen Masse 3, die mit Hohlräumen 6 versehen ist, umgeben. Anschließend wird diese Anordnung mit einer gefüllten Plastikmasse 4 umhüllt.

Im Ausführungsbeispiel nach Fig. 2 wird nur die Oberfläche des Halbleiter-Chips 1 mit der dauerelastischen Masse 3, die mit Hohlräumen 6 versehen ist, bedeckt.

Bei Verwendung eines Harzes als Plastikmasse und von Füllstoffen aus Quarzmehl oder Aluminiumoxid kann diese Umhüllung, wie z. B. in der DE-OS 21 64 110 beschrieben, in der Weise durchgeführt werden, daß der Füllstoff einem dünnflüssigen Harz beigemengt wird, welches beispielsweise in vorpolymerisiertem oder vorkondensiertem Zustand vorliegt und die dadurch entstehende Masse zur Entgasung erwärmt wird und anschließend zur Umwandlung in einen glasartigen Hartzustand starkt gekühlt und sodann zu Pulver oder Granulat zermahlen wird. Die eigentliche Einkapselung der Anordnung mittels Preßformen kann dann beispielsweise derart erfolgen, daß die in einem Behälter eingebrachte körnige Einkapselungsmasse in diesem bis zur Plastifizierung erwärmt und unter Druck dosiert in die Form gepreßt wird und bei entsprechender Temperatur der Form aushärtet.

Die Hohlräume 6 innerhalb der dauerelastischen Masse 3 sorgen für Elastizität und Nachgiebigkeit dieser Masse auch nach der Umhüllung mit einer harten, gefüllten Plastikmasse 4, so daß Beschädigungen der Kontaktierdrähte 2 und ähnliches vermieden wird.

Als dauerelastische Massen werden vorteilhafterweise Elastomere, d. h. synthetische und natürliche Polymere mit gummielastischem Verhalten, wie z. B. Silikonkautschuk oder Polyimide, verwendet.

Die Hohlräume 6 innerhalb der dauerelastischen Masse 3 werden z. B. durch Aufschäumen der dauerelastischen Masse, bevor diese auf den Halbleiter-Chip 1 aufgebracht wird, erzeugt.

Dieses Aufschäumen kann durch chemische Zusätze zur dauerelastischen Masse 3, die eine unter Gasentwicklung ablaufende Reaktion hervorrufen und/oder durch eine Temperaturbehandlung erzeugt werden.

Wird die dauerelastische Masse 3 mit einem Lösungsmittel verdünnt, so ist es z. B. vorteilhaft, zunächst die verdünnte dauerelastische Masse (3) aufzubringen und diese dann so schnell auf eine Temperatur nahe dem Siedepunkt des Lösungsmittels zu erhitzen, daß die Masse 3 schaumig wird, bevor sie aushärtet.

Wird die dauerelastische Masse 3 mit Wasser emulgiert,
ist es vorteilhaft, die emulgierte Masse 3 so schnell auf
eine Temperatur nahe dem Siedepunkt des Wasser zu erhitzen,
daß die Masse schaumig wird, bevor sie aushärtet.

Wird als chemischer Zusatz ein Treibmittel, z. B. Ammoniumkarbonat, verwendet, so wird die mit dem Zusatz versehene
dauerelastische Masse 3 bis zur Zersetzung des Treibmittels
erhitzt.

2 Figuren
10 Patentansprüche

Patentansprüche

1. Verfahren zum Herstellen von Halbleiter-Bauelementen, bei dem ein Halbleiter-Chip mit einer dauerelastischen Masse abgedeckt und mit einem mit einem Füllstoff gemischten Kunststoff umhüllt wird, d a d u r c h  g e - k e n n z e i c h n e t , daß die dauerelastische Masse (3) mit Hohlräumen (6) versehen wird.

2. Verfahren nach Anspruch 1, d a d u r c h  g e - k e n n z e i c h n e t , daß die dauerelastische Masse (3) geschäumt wird.

3. Verfahren anch Anspruch 2, d a d u r c h  g e - k e n n z e i c h n e t , daß die dauerelastische Masse (3) mittels chemischer Zusätze geschäumt wird.

4. Verfahren nach einem der Ansprüche 1 bis 3, d a - d u r c h  g e k e n n z e i c h n e t , daß die dauerelastische Masse (3) mittels eines Lösungsmittels, mit dem die dauerelastische Masse (3) verdünnbar ist, geschäumt wird.

5. Verfahren nach einem der Ansprüche 2 bis 4, d a - d u r c h  g e k e n n z e i c h n e t , daß die dauerelastische Masse (3) durch eine Temperaturbehandlung geschäumt wird.

6. Verfahren nach einem der Ansprüche 1 bis 5, d a - d u r c h  g e k e n n z e i c h n e t , daß als dauerelastische Masse (3) Silikonkautschuk verwendet wird.

7. Verfahren nach einem der Ansprüche 1 bis 6, d a - d u r c h  g e k e n n z e i c h n e t , daß als dauerelastische Masse (3) Polyimid verwendet wird.

8. Verfahren nach einem der Ansprüche 1 bis 7, d a - d u r c h   g e k e n n z e i c h n e t , daß als chemischer Zusatz Ammoniumkarbonat oder Wasser verwendet wird.

9. Verfahren nach einem der Ansprüche 1 bis 8, d a - d u r c h   g e k e n n z e i c h n e t , daß nach dem Aufbringen der verdünnten oder emulgierten dauerelastischen Masse (3) diese auf eine Temperatur in der Nähe des Siedepunktes des Lösungs- bzw. Emulgierungsmittels gebracht wird.

10. Verfahren nach einem der Ansprüche 1 bis 8, d a - d u r c h   g e k e n n z e i c h n e t , daß bei Verwendung von Treibmitteln als chemischer Zusatz, die dauerelastische Masse bis zur Zersetzung des Treibmittels erhitzt wird.

FIG 1

FIG 2